Europäisches Patentamt

European Patent Office

Office européen des brevets

(19)

(11) Publication number: **0 032 028**
**B1**

# EUROPEAN PATENT SPECIFICATION

(12)

(45) Date of publication of patent specification: **21.08.85**

(51) Int. Cl.⁴: **H 01 L 21/90,** H 01 L 21/31

(21) Application number: **80304609.3**

(22) Date of filing: **19.12.80**

(54) Method and apparatus for forming electrical interconnections.

(30) Priority: **19.12.79 JP 164105/79**
**19.12.79 JP 174803/79 u**
**18.06.80 JP 84241/80 u**

(43) Date of publication of application:
**15.07.81 Bulletin 81/28**

(45) Publication of the grant of the patent:
**21.08.85 Bulletin 85/34**

(84) Designated Contracting States:
**DE FR GB**

(56) References cited:
**US-A-3 678 348**
**US-A-4 058 438**

**IBM TECHNICAL DISCLOSURE BULLETIN, vol. 10, no. 3, August 1967, New York, US, E.S. MATHISEN: "Etch control probe", pages 193-194**

(73) Proprietor: **SIGMA CORPORATION**
**1-3-15, Komagome Toshima-ku**
**Tokyo (JP)**

(72) Inventor: **Kanda, Kunihiko**
**39-7, Sumiregaoka Kohoku-ku**
**Yokohama-shi Kanagawa-ken (JP)**

(74) Representative: **Stephens, Michael John et al**
**M.J. Stephens & Co. 46 Tavistock Place**
**Plymouth PL4 8AX (GB)**

(56) References cited:
**THIN SOLID FILMS, vol. 10, no. 2, May 1972, Lausanne, CH, J.P. RIOULT et al. "A new method for the evaluation of the surface condition of aluminium yielding new insight into IC multilevel interconnection problems", pages 283-300**

# Description

The present invention relates to a method of forming electrical interconnections on a semiconductor substrate by the wet chemical etching of an electrically conductive layer formed on the substrate, the method involving the monitoring of the progress of the etching whereby to ascertain the terminal point of etching; the invention also relates to apparatus for carrying out the above method.

In forming electrical interconnections on a semiconductor substrate for the purpose of interconnecting regions of various semiconductor circuit elements formed on the substrate, there has been adopted a process in which an electrically conductive layer deposited on the substrate is selectively removed by chemical etching using an etching solution. In this etching process, however, there is no appropriate method for monitoring the progress of the etching. Accordingly, the etching process has heretofore been controlled mainly by the skill of the operators. If the temperature of an etching solution and the etching time are strictly controlled, the etching process can be performed by skilled operators. However, as the degree of integration of electrical interconnections is increased with an increase of the degree of integration of semiconductor circuit elements, the interconnections on the substrate are made finer and distances between every two adjacent lines are narrowed, with the result that a pattern becomes more complicated and a high precision is required. Accordingly, in the conventional method, variations often occur even in the case of skilled operators, and over-etching or insufficient etching is frequently found.

Furthermore, there is known a process for forming electrical interconnections of an electrically conductive layer by electrolytic etching of a conductive layer. More specifically, an electric voltage is applied between two electrodes (one of which includes the substrate to be etched) to cause an electric current to flow between the electrodes and to effect etching. This process, however, suffers from a number of drawbacks. For example, a direct current voltage is indispensable, and since etching is quickly advanced, fine control becomes difficult. Furthermore, when a plurality of substrates are simultaneously etched, electrodes must be connected to all of the substrates. Accordingly this process is not practically applied to the manufacture of semiconductor devices.

US—A—4 058 438 describes an electrolytic cell used to determine when a metal sample has been properly prepared by etching for resistance welding and/or adhesive bonding. To this end a calomel electrode is inserted in the etchant and the metal sample is used as the second electrode to form the said electrolytic cell. The potential set up by this cell is monitored and when it stabilises the surface of the sample is deemed ready for resistance welding and/or adhesive bonding.

It is a primary object of the present invention to provide a method of monitoring the progress of chemical etching which can be effected without relying on the skill of an operator.

Another object of the present invention is to provide a method of forming electrical interconnections of high quality, in which etching is consistantly carried out.

According to one aspect of the present invention, there is provided a method of forming electrical interconnections on a semiconductor substrate formed with a number of semiconductor circuit elements, said method comprising depositing an electrically conductive layer over substantially the entire surface of the semiconductor substrate, and etching the electrically conductive layer to produce electrical interconnections in a pattern previously defined on the conductive layer by a photolithographic process, characterised in that the etching process includes the operations of placing a connecting element composed of the electrochemically same material as that of the electrically conductive layer so that at least one point of said connecting element is in contact with the electrically conductive layer, dipping the assembly in an etching solution to perform wet chemical etching of the electrically conductive layer, and monitoring the progress of etching by monitoring the electric current flow produced in an external circuit by an electrochemical cell set up between the electrically conductive layer acting as one electrode and another electrode disposed in said solution and constituted by an electric conductor composed of a material electrochemically different from the material of the electrically conductive layer, the cell electrode constituted by the conductive layer being connected to the external circuit by said connecting element.

The electric current produced between an electrode formed by the conductive layer (typically aluminium) carried by the semiconductor wafer, and the other electrode (for example, a platinum wire) changes according to the area of exposed aluminium of the semiconductor wafer. More specifically, since the area of exposed aluminium is large in the initial stage of etching, a large current is obtained, but at termination of the etching, the area of exposed aluminium is small and therefore, the current is small.

In order to prevent electrolytic corrosion of the conductive layer due to electrochemical action between this layer and the said connecting element, an aluminium wire composed of the same material as that of the electrically conductive layer is used as the connecting element to be taken out from the semiconductor wafer. Furthermore, the aluminium of said connecting element can increase the size of electric current flowing in the monitoring electrochemical cell so that the residual current at the end of etching is greater than would otherwise be the case with the result that the percentage change of the electric current at termination of etching is reduced and detection of termination of etching becomes difficult. This problem can be overcome by coating the connecting element with an insulating material so that the exposed area of the connecting element is reduced.

Ordinarily, a semiconductor wafer has convexities and concavities formed by etching treatment for opening diffusion windows, and therefore, in many cases, the semiconductor wafer is contacted by the connecting element by line or point contact. Accordingly, the actual monitoring current value will depend on the kind of the diffusion treatment conducted on the contact points, and detection of the termination of the etching becomes even more difficult. This defect is eliminated by surrounding the periphery of the connecting element with an elastic resin.

In forming electrical interconnections on a semiconductor substrate, there is generally used a method in which a photoresist is coated on a substrate on which aluminium is vacuum-deposited, a mask is placed on the photoresist, the assembly is exposed to actinic rays to effect a development treatment, a baking treatment is then performed, and aluminium is selectively removed by using an etching solution.

To monitor the selective etching of the vacuum-deposited aluminium in accordance with the method of the present invention, one or more connecting elements must be taken out from the conductive layer formed in the substrate.

Since a photoresist, which is an electrical insulator, is coated on the electrically conductive layer formed on the substrate, care must be taken to ensure that the electrically conductive layer is assuredly connected to the said connecting element as otherwise monitoring of the progress of the etching by monitoring the current cannot be accurately performed. Furthermore it is also necessary to ensure that the interconnecting leads connecting the connecting element and the other electrode are not cut.

If only one connecting element is connected to the electrically conductive layer, for example, by means of a connector, connection cannot be confirmed and a fault cannot be detected until the assembly is dipped in an etching solution. Accordingly, in this case, the operational efficiency is extremely low. Furthermore, when a fault is detected, the assembly must be removed from the etching solution and dipped again after connection has been properly made. Therefore, it is difficult to calculate the etching time and it becomes impossible to perform appropriate etching.

The foregoing difficulties can be overcome by providing a connector which serves to press-adhere at least two connecting elements to the conductive layer on the substrate and which enables the proper connection of these connecting elements to the electrically conductive layer to be checked.

The present invention will now be described in detail with respect to formation of electrical connecting lines on a semiconductor wafer with reference to the accompanying drawings.

Fig. 1 is a current-time graph illustrating the time variation of the electric current produced by an electrochemical cell used to monitor the progress of chemical etching of an aluminium layer deposited on a substrate, the aluminium layer forming one electrode of the cell;

Fig. 2 is a diagram illustrating an etching tank and an electric circuit of one form of apparatus of the present invention;

Fig. 3 is a graph similar to Figure 1 illustrating the changes in monitoring current when a substrate 2 of Fig. 2 is dipped in an etching solution 8 to effect etching;

Fig. 4 is a diagram illustrating a form of apparatus of the invention in which the electrolytic etching effect of the monitoring current effect is reduced;

Figs. 5 and 6 are sectional views of a semiconductor respectively before and after etching;

Fig. 7 is a plan view showing a plurality of IC chips formed on a single substrate and of one of the IC chips, shown separately, on a much enlarged scale;

Figs. 8, 9 and 10 each illustrate a respective further form of apparatus of the invention including an etching tank and an associated monitoring circuit;

Fig. 11 is a graphical illustration of the change in monitoring current with time which occurs in use of the method of the present invention;

Fig. 12 is a diagrammatic illustration of an etching tank forming part of apparatus according to a further embodiment of the invention;

Figs. 13 and 14 are a top plan view and a cross-sectional view respectively of a first embodiment of a connector forming part of the apparatus of the invention;

Fig. 15 is a diagrammatic illustration of the connector of Figures 13, 14 in use in apparatus according to the invention;

Figs. 16 and 17 are a top plan view and a cross-sectional view respectively of a second embodiment of a connector forming part of the apparatus of the invention;

Fig. 18 and 19 are a top plan view and a cross-sectional view respectively of a third embodiment of a connector forming part of the apparatus of the invention; and

Fig. 20 is a sectional view taken on line A—A of Fig. 19.

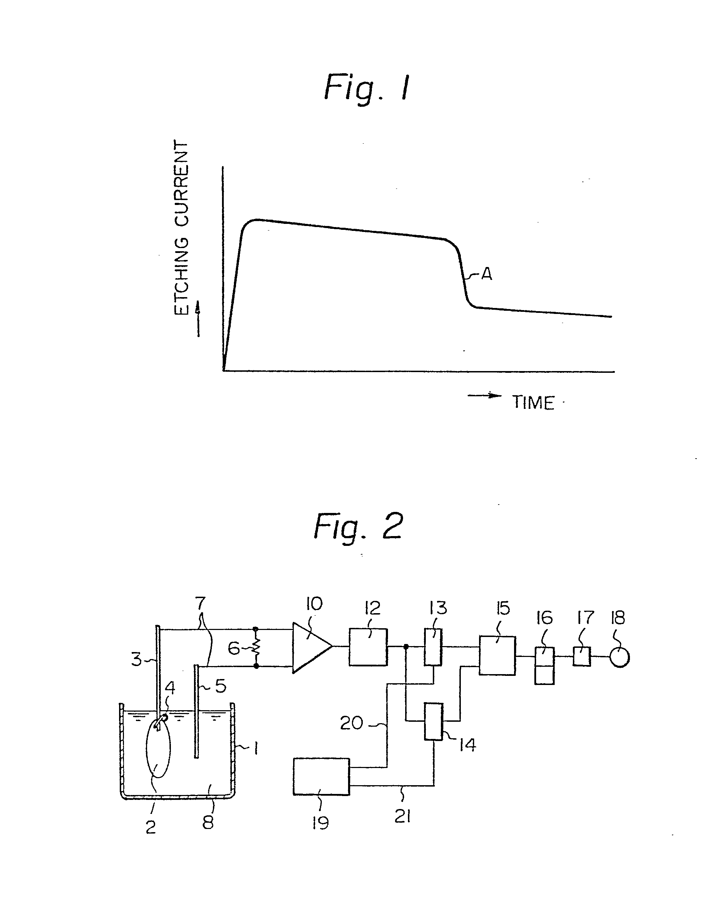

The basic principle of the electrical-connection forming methods to be described hereinafter, is to form conductive tracks by the chemical etching of a conductive layer formed on a substrate, while monitoring the progress of etching by monitoring the electrical current flow produced by an electrochemical cell set up between the conductive layer, acting as one electrode, and another electrode disposed in the etching solution. Figure 1 illustrates a typical form of current-time curve for the monitoring current. Since the value of the current flowing between the electrodes during etching changes according to the exposed area of the conductive layer, when the etching process is nearing completion and the area of the conductive layer is rapidly reducing as a pattern is cut in portions thereof, the current value will fall substantially. Therefore, a point of primary termination (point A) can be detected. However, since the thickness of the conductive layer (for example, vacuum-deposited aluminium) is not absolutely uniform, unwanted conductive material is still left locally at this primary termination point, and therefore, additional etching should be performed.

The time for this additional etching can be determined based on the measurement of the change of the etching monitoring current. However, there are many factors affecting a change of the monitoring current, such as the surface area of a connecting element used to make contact with the conductive layer, and the etching current does not precisely represent the etching speed. Therefore, this method of determining the additional etching time is disadvantageous in that an appropriate etching time cannot be precisely determined.

As will be more fully described hereinafter, this defect can be eliminated by forming electrical interconnections while calculating an optimum time for etching an electrically conductive layer by utilizing means for monitoring the progress of the etching, means for measuring the etching speed, means for storing the initial thickness of the electrically conductive layer, and computing means.

A detailed description of various forms of apparatus for effecting the method of the invention will now be described.

In Fig. 2, reference numerals 1, 2 and 3 respectively indicate an etching tank, a substrate having aluminium vacuum-deposited thereon, and an aluminium wire. A holding member 4 composed of a resin is provided to bring the aluminium vacuum-deposited on the substrate 2 into contact with a connecting element constituted by an aluminium wire 3, and to maintain them in this contacted state. Reference numerals 5, 6, 7, 8, 10 and 12 respectively indicate a platinum wire, a resistor, connecting leads, an etching solution comprising phosphoric acid as the main ingredient, an amplifier and an analog-digital converter. Reference numerals 13 and 14 indicate registers, and reference numerals 15, 16, 17, 18, 19, 20 and 21 respectively indicate a comparator circuit, a flip-flop, a driver, a buzzer, a control circuit, an initial sample signal line and an inspection sample signal line.

After aluminium is vacuum-deposited on the substrate 2, then, as is standard, a photoresist is applied thereon followed by a mask and the whole assembly is exposed to actinic rays to effect a development treatment. Then, a baking treatment is carried out and aluminium in the area where the photoresist is not applied is selectively removed by using the etching solution 8.

In order to monitor the progress of the etching, an electrochemical cell is set up between the aluminium on the substrate 2 and the platinum wire 5. Connection to the aluminium on the substrate is made by means of the connecting element 3. The resistor 6 is connected to the platinum wire 5 and to the connecting element 3 through the connecting leads 7. When the assembly is dipped in the etching solution 8, the electrochemical cell set up causes an electric current to flow through the resistor 6, the platinum wire 5 acting as a positive pole and the conductive layer acting as a negative pole.

The connecting element 3 contacting the electrically conductive layer on the substrate 2 should be composed of an electrochemically same material as that of the electrically conductive layer. In other words, the material of the element 3 should have the same electrochemical potential as that of the electrically conductive layer. If the element 3 is composed of a material electrochemically· different from the material of the electrically conductive layer, then since both the substrate 2 and the element 3 brought into contact therewith are dipped in the etching solution 8, a short circuit is formed in the contact portion and etching is completed preferentially in the periphery of the contact portion, while no circuit is formed in the other portion of the electrically conductive layer. Therefore, in such a case, correct monitoring of the progress of the etching is impossible.

In the present embodiment, the platinum wire 5 is used as the counter electrode for the substrate 2. In fact, provided an electrically conductive substance electrochemically different from the material of the electrically conductive layer is used as the counter electrode, an electrochemical cell is produced. Therefore any such electrically conductive substance can be used instead of the platinum wire 5, to implement the method of the present invention.

The electric voltage produced by the electric current flowing through the resistor 6 is amplified by the amplifier 10 and converted to a digital signal by the analog-digital converter 12.

The electric current produced in the initial stage of etching of the substrate 2 is set in the register 13 through the initial sample signal line 20. Then, the electric current is set in the register 14 through the inspection sample signal line 21 at predetermined intervals of, for example, 30 seconds. The content of the register 13 is compared with the content of the register 14 by the comparator circuit 15. When the current value is below 70% of the initial current value, the flip-flop 16 is set and the buzzer 18 is actuated by the driver 17, whereby an operator is informed that termination of etching is close at hand. Of course, not only the buzzer 18 but also another indicator may be used as the informing means. The above-mentioned ratio of the monitored current to the initial current is not limited to 70%, but a ratio of 60% through 80% may be adopted.

If the initial current value is adopted as the reference value as in the present embodiment, a signal indicating the terminal point can appropriately be produced according to the size of the substrate 2. In the present embodiment, comparison is made after the analog signal has been converted to a digital signal. However, there may be adopted a modification in which the electric current value produced in the initial stage of etching is stored in a condenser and the analog voltage held therein is compared with an analog signal of a voltage converted from a sampled current. In the present embodiment, the terminal point is determined by comparing the sampled current with the initial current. However, the intended objects of the present invention can similarly be attained in a modification where such comparison is not made but termination is detected by confirmation of lowering of the electric current value to a sufficiently low level.

Furthermore, there also may be adopted a modification in which a memory capable of storing many sampled currents is provided instead of the register 13, and the sampled current is compared with another current sampled before a certain time, for example, 2 minutes, whereby to detect the terminal point. In this modification, the same signal that is supplied to the inspection sample signal line 21 is supplied to the initial sample signal line 20.

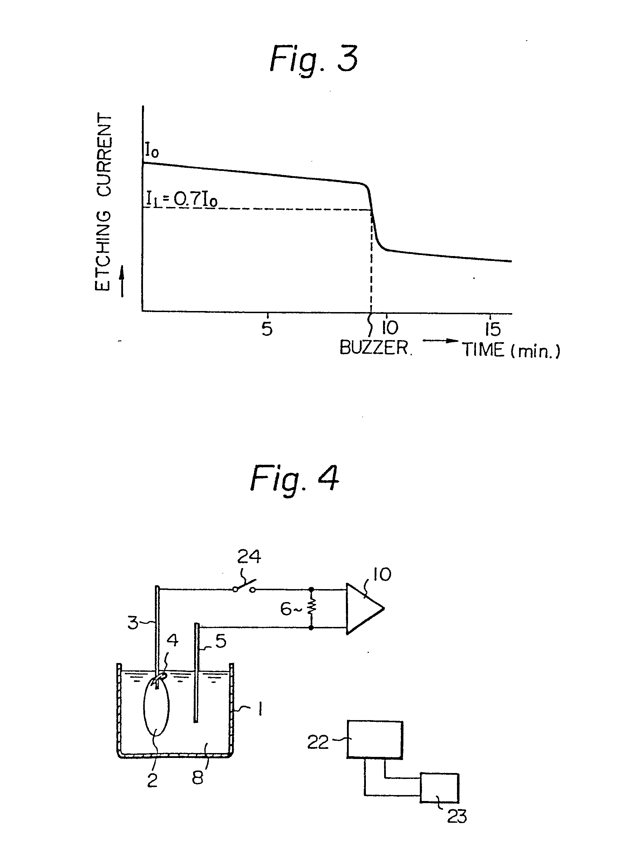

Since the current value depends on the area of exposed aluminum, the current value is greatly reduced when etching comes close to the point of termination. Accordingly, the point of termination of etching can easily be detected by the above-mentioned procedures. In the embodiment shown in Fig. 3, the buzzer is actuated when the sampled current $I_L$ is reduced to 70% of the initial current Io.

As can be understood from the foregoing description, even if the etching tank 1 is disposed in a chamber or the like and a cover is arranged thereon and it is difficult to inspect the substrate 2 with the naked eye, the progress of the etching can be detected according to the present invention.

When a circuit as illustrated in Fig. 2 is used, ionization of the aluminium layer is influenced by the monitoring current. Accordingly, in the case where a plurality of substrates are simultaneously etched and one of them is monitored by the circuit illustrated in Fig. 2, then because of the affect of the current on ionization of the aluminium, there is a time difference between the termination of the etching process for the monitored wafer and the remaining wafers. An embodiment for reducing this current effect is illustrated in Fig. 4.

In Fig. 4, reference numeral 22 represents an improved form of the control circuit 19 illustrated in Fig. 2. Reference numerals 23 and 24 respectively indicate a relay and a contact of the relay 23.

Just before setting electric current values in the registers 13 and 14 through the initial sample signal line 20 and inspection sample signal line 21 in Fig. 2, the relay 23 shown in Fig. 4 is actuated to close the contact 24, and after completion of loading of the registers 13 and 14, the relay 23 is de-energized to open the contact 24. If this arrangement is adopted so that an electric current is allowed to flow only for several milliseconds at the time of the measurement, the current etching effect can substantially be ignored.

In this embodiment, the relay 23 is used for the switching operation. If a semiconductor such as a transistor is used for this switching operation, the time of flowing of the electric current can be shortened and the current effect can further be reduced.

The substrate 2 of the foregoing embodiments need not be composed of a completely insulating material. If a substrate which is sufficiently more difficult to electrolyze than the electrically conductive layer is used, a sufficient change of the current value is brought about at the termination of etching to enable the termination of etching to be detected according to the above-mentioned procedures.

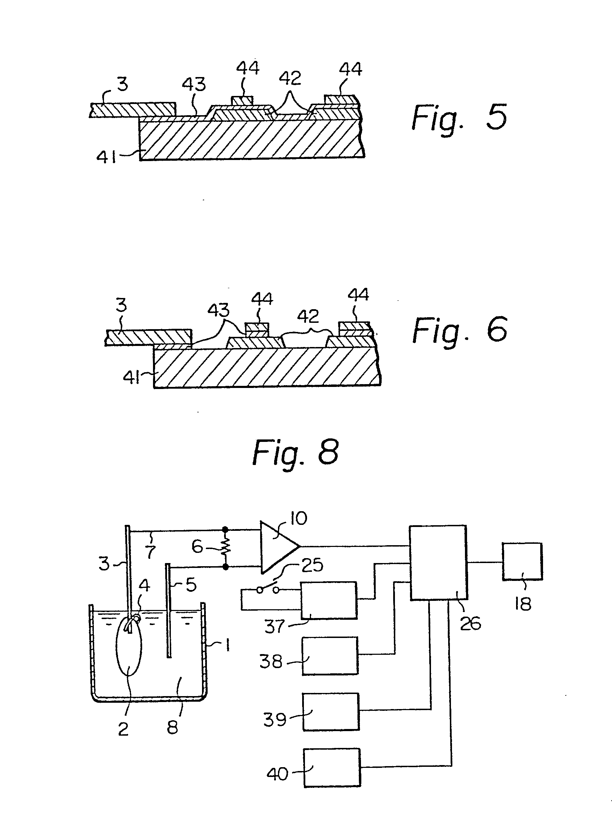

Fig. 5 is a sectional view illustrating circuit elements of a semiconductor before etching and Fig. 6 is a sectional view illustrating circuit elements of the semiconductor after etching, the general form of the semiconductors being known.

In Figs. 5 and 6, reference numerals 41, 42, 43 and 44 indicate a semiconductor silicon wafer or substrate, an insulating layer of silicon dioxide or the like, a vacuum-deposited aluminium layer and a photoresist according to a pattern of electrical interconnections.

When etching is carried out by bringing the aluminium wire 3 into contact with the aluminium layer 43, the aluminium layer 43 in the area where the photoresist 44 is not applied is selectively removed as illustrated in Fig. 6. Since the thickness of the aluminium layer 43 is 4000 through 15000 Å, if an aluminium wire having a diameter sufficiently larger than this thickness, for example, 0.1 mm, is used as the aluminium wire 3, it is possible to prevent the aluminium wire 3 from being preferentially etched and cut.

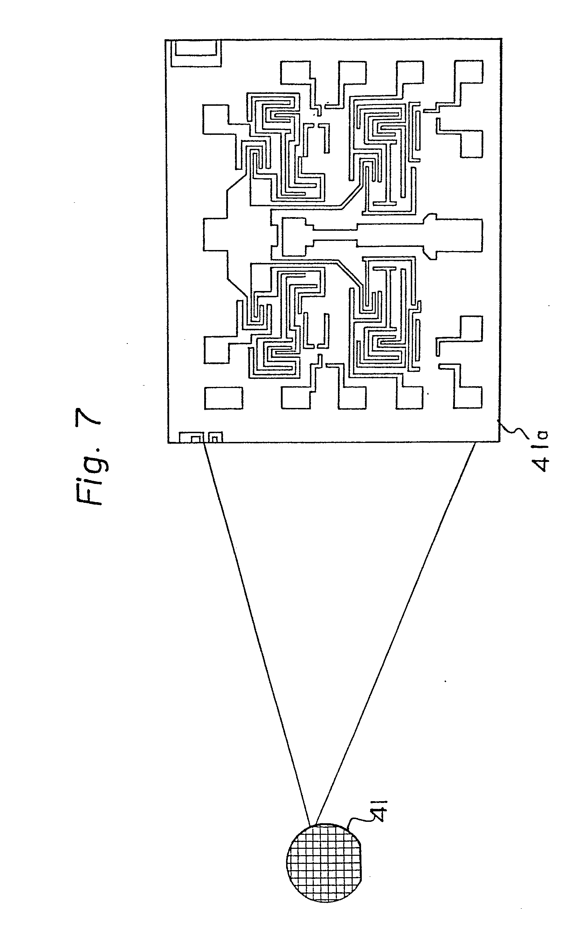

As illustrated in Fig. 7, a great number of IC chips 41a are generally formed on a semiconductor substrate 41, and electrical interconnections of a complicated pattern are formed for these IC chips 41a. In the method of the present invention, if only an electrical interconnections pattern for one IC chip 41a is connected to the aluminium wire and the etching state of this pattern alone is inspected according to the method of the present invention, desired electrical interconnections can also be formed for the other IC chips 41a. It is considered that the reason for this is that interconnection layers of the respective IC chips 41a are electrically connected with the aluminium wire through the semiconductor substrate.

As will be apparent from the foregoing description, etching can be performed with a very high scientific precision and also with good reproducibility irrespective of the skill or experience of an operator and therefore, electrical interconnections of high quality can be formed in high yields.

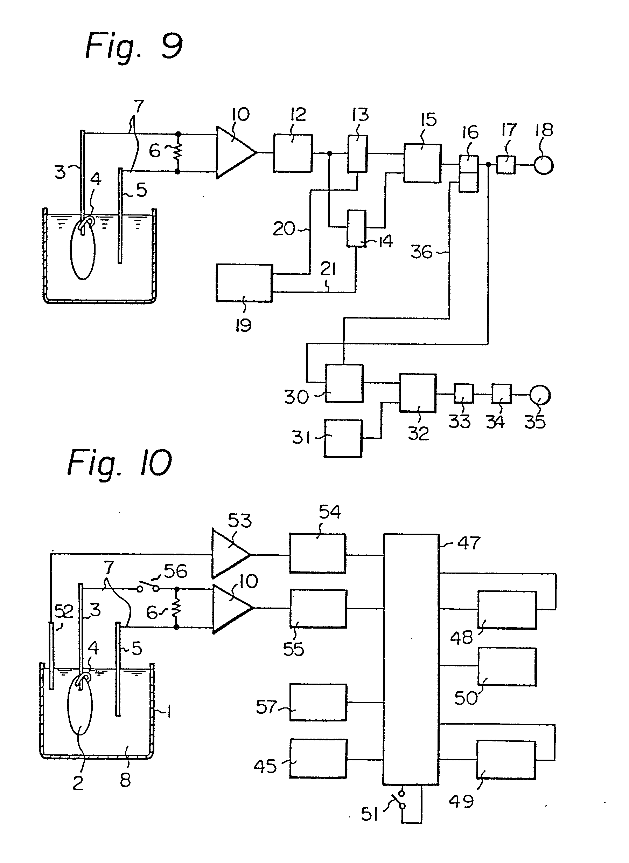

Fig. 8 is a diagram illustrating an etching tank and monitor circuit according to the present invention.

In Fig. 8, reference numerals 10, 37, 38, 39, 40 and 26 respectively indicate the amplifier, a timer, a switch for setting the initial thickness of the aluminium conductive layer 2 for electrical interconnections of a wafer, a standard current setting circuit for detecting when etching approaches the terminal point, a thumb wheel switch for setting the additional etching thickness for additional etching to be conducted after detection of the approach to the terminal point, and a processing unit. Reference numeral 18 indicates the buzzer, and reference numeral 25 indicates a starting switch.

When the wafer 2 is placed in the etching tank 1 and the start switch 25 is depressed, the timer 37 is actuated to measure the etching time. The electric current produced by the monitoring electrochemical cell is converted to a voltage by the resistor 6, amplified by the amplifier 10 and supplied to a processing unit 26 for comparison with the value of the standard current setting circuit 39. If the value of the etching current falls below the value of the standard current setting circuit 39, the processing unit 26 reads an output T of the timer 37 and an output W of the initial thickness setting thumb wheel switch 38 at this point and calculates the quantity etched per unit of time, that is, the etching rate W/T, and then, the processing unit 26 reads the output W' of the additional etching thickness setting thumb wheel switch 40 and calculates the additional etching time

$$\frac{W'}{W}T$$

by dividing the read value by the above-mentioned etching rate. When the output T of the timer 37 becomes equal to

$$T+\frac{W'}{W}T,$$

the buzzer 18 is activated to indicate completion of etching.

According to this embodiment of the present invention, since the etching rate is calculated for each cycle of etching, it is possible to handle delicate changes in the etching conditions (such as changes in the composition of the etching solution 8 and the temperature of the etching solution 8) appropriately, and therefore, etching can be carried out uniformly and electrical interconnections of high quality can be obtained. Moreover, even if many experiments are not particularly made for determining optimum etching conditions, desired etching can be performed effectively.

In the present embodiment, two switches, that is, the thumb wheel switch 38 for setting the initial thickness of the electrically conductive layer and the thumb wheel switch 40 for setting the additional etching thickness, are provided. However, since the initial thickness W of the electrically conductive layer and the additional etching thickness W' are known in advance, the intended objects of the present invention can similarly be attained even if only one switch for setting the ratio W'/W is provided.

In Fig. 9, which illustrates yet another embodiment of the present invention, reference numerals 1 through 21 indicate the same elements and members as in Fig. 2. Reference numerals 30, 31, 32, 33, 34, 35 and 36 indicate a timer, a time setting switch, a comparator circuit, a flip-flop, a driver, a buzzer and a reset signal line of the flip-flop 16, respectively.

When the flip-flop 16 is set, the timer 30 is started, and after several seconds, the flip-flop 16 is reset by the reset signal line 36 and ringing of the buzzer 18 is stopped. The timer 30 is kept actuated and the time counted by the timer 30 is compared with the time set by the time setting switch 31 by the comparator circuit 32. When both the times become equal to each other, the flip-flop 33 is set and the buzzer 35 is actuated through the driver 34 to indicate termination of etching. According to this embodiment, etching is continued for a certain time after the monitoring current has reached a predetermined level,. for example, 70% of Io (see Fig. 3), and therefore, non-uniformity of the degree of etching owing to a difference of the size or shape of the patterns on the substrate can effectively be eliminated in the formed interconnections.

Fig. 10 is a diagram illustrating another etching tank and monitor circuit according to the present invention. In Fig. 10, reference numerals 1 through 10 indicate the same elements and members as in Fig. 2. Reference numerals 45, 47, 48, 49, 50, 51, 52, 53, 54, 55, 56 and 57 respectively indicate an additional etching thickness memory circuit for storing the thickness of additional etching to be conducted after detection of the terminal point of etching, a processing unit provided with a computing and controlling capacity, a monitoring current memory circuit a timer, a buzzer, a start switch, a thermocouple for measuring the temperature of the etching solution 8, an amplifier, an AD converter, another AD converter, a contact of a reed relay, and a thickness memory circuit for storing the initial thickness of the aluminium conductive layer of the substrate 2; the circuits shown as reference numerals 45 and 57 can also be formed as one circuit.

In order to monitor the progress of etching of aluminium vacuum-deposited to the substrate 2, the electric current flowing through the aluminium wire 3 is monitored in the same manner as in the embodiment illustrated in Fig. 2 except for the following changes.

When the substrate 2 is placed in the etching tank 1 and the start switch 51 is depressed, the timer 49 is actuated to perform measurement of the etching time, and a signal from the timer 49 is fed to the processing unit 47 at predetermined intervals of, for example, 30 seconds. On receipt of a signal from the timer 49, the processing unit 47 closes the contact 56 of the reed relay for about 10 milliseconds to measure the monitoring circuit. This circuit is converted to a voltage by the resistor 6, amplified by the amplifier 10, put into the processing unit 47 and compared with the value of the monitoring current memory circuit 48.

When the difference between the compared currents is small, the newly measured current value is stored in the monitoring current memory circuit 48. When the newly measured current value is much smaller than the previously measured current value, that is, the value stored in the monitoring current memory circuit 48, it is judged that the etching process has reached the primary terminal point (point A) illustrated in Fig. 1.

The temperature of the etching solution 8 is sensed by the thermocouple 52, amplified by the amplifier 53, converted to a digital signal by the AD converter 54 and fed to the processing unit 47.

The temperature of the etching solution 8 is measured by the thermocoupled 52 under the control of the timer 49, for example, at intervals of 10 seconds.

When the relation between the temperature $(T')$ of the etching solution consisting of 85% phosphoric acid, and the change in etching thickness per unit time, that is the etching rate (R), is determined by experiments, it is seen that the following relation is established:

$$R \fallingdotseq A \times 1.11^{T'}$$

wherein A stands for a constant.

When R/A is expressed as R', the above formula can be written as follows:

$$R' \fallingdotseq 1.11^{T'}$$

The total thickness etched Q, up to a time M1 at a primary terminal point corresponds to a time integration of R' which is represented by the following formula:

$$Q = \int_0^{M1} 1.11^{T'} dM$$

wherein M stands for the etching time.

This total etched thickness Q approximates the total sum of the products of the time $\Delta M$ and R' calculated each time the temperature is measured. That is the total etched thickness Q is approximately represented by the following formula:

$$Q = \sum_0^{M1} (1.11^{T'} \times \Delta M)$$

In the processing unit 47, the value S is read out from the initial thickness memory circuit 57 and the value W' is read out from the additional etching thickness memory circuit 45, and the value of SQ is calculated where S represents

$$\frac{W'}{W}$$

which is the ratio of the additional etching thickness of an electrically conductive layer to the initial thickness and which may be expressed by a percentage.

After the primary terminal point A the temperature is measured at intervals of, for example 2 seconds, and at every measurement, a value P is calculated according to the following formula:

$$P = SQ - \sum_{M1}^{M} (1.11^{T'} \times \Delta M)$$

When the value P is close to 0, etching is terminated and the buzzer 50 is actuated.

According to this embodiment, since etching is carried out while measuring the temperature of the etching solution, even if the etching solution 8 is heated by a heater to elevate the temperature of the etching solution 8 and accelerate etching, termination of etching can be detected appropriately and precisely.

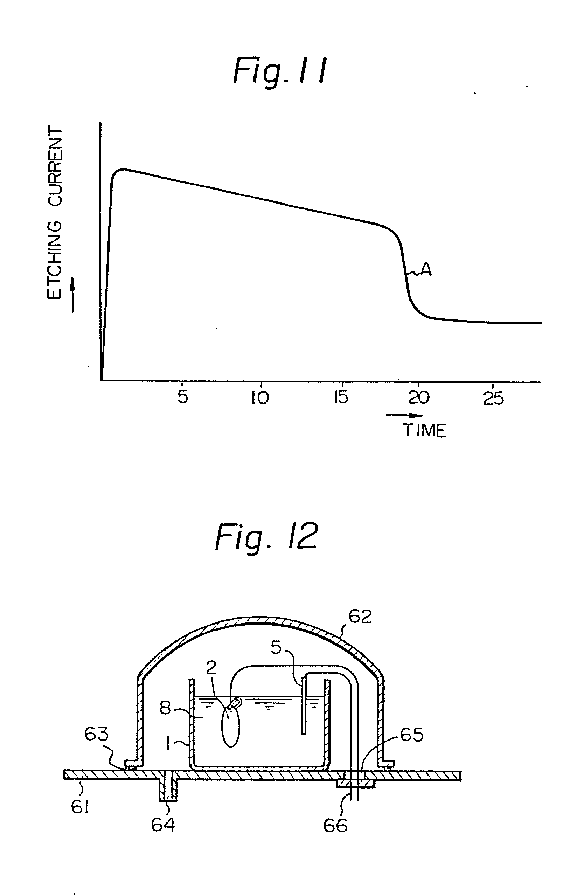

Fig. 11 is a diagram illustrating the change of the monitoring current with a lapse of time according to the present invention. More specifically, characteristics observed when a substrate having aluminium vacuum-deposited thereon in a thickness of 1200 nm (12000 Å) is dipped in an etching solution consisting of 85% phosphoric acid and etching is carried out at 40°C. are illustrated in Fig. 11. In this case, the time required for etching to arrive at the primary terminal point A is about 20 minutes, and an appropriate time for the additional etching is about 90 seconds when the value set in an additional etching thickness memory circuit is 7.5 percent.

According to the present embodiment, since an optimum etching time is calculated for each cycle of etching by measuring the temperature of the etching solution 8, etching can be performed while appropriately handling delicate changes of etching conditions such as the temperature of the etching solution and the quality of aluminium vacuum-deposited on the substrate 2. Therefore, etching can be performed uniformly and electrical interconnections of high quality can be formed. Moreover, even if various experiments are not particularly made for determining optimum conditions, desired etching can be performed appropriately and precisely.

According to the present embodiment, since the contact 56 of the reed relay is closed for 10 milliseconds at every interval of 30 seconds, the variation of the etching time due to the flow of electric current can substantially be ignored. Therefore, even when a great number of substrates are simultaneously etched, the intended effects can be attained by monitoring only one substrate. If a semiconductor switch is used instead of the reed relay, the etching current can be measured by closing the switch only for a much shorter time, for example, 100 micro seconds.

If the resistance value of the resistor 6 is increased, the influence of etching can be reduced even when the contact 56 of the reed relay is not used. Accordingly, the intended effects of the present invention can similarly be attained also by this modification.

In the present embodiment, a freely settable thumb wheel switch may conveniently be used for each of the initial thickness memory circuits 57 for storing the initial thickness of the aluminum conductive layer, and the additional etching quantity memory circuit 45. However, the intended objects can similarly be attained even if a fixed memory, such as a read-only memory, is used instead of the above switch.

In the present embodiment, the newly measured current value is compared with an immediately preceding measured value for determination of the primary terminal point A. However, in the present invention, there may be adopted a modification where the newly measured current value is compared with a current value measured two or three samplings before the newly measured value.

Fig. 12 illustrates an embodiment where etching is carried out under reduced pressure.

In Fig. 12, reference numerals 61, 62, 63, 64, 65 and 66 represent an attachment stand formed of stainless steel, a bell jar formed of glass, an air-tight packing, a pressure reduction opening, a signal line take-out opening and an electrode introduction terminal, respectively.

The etching tank 1 containing the substrate 2 and the platinum wire 5 dipped in the etching solution 8 is placed in the bell jar 62, and a signal line is drawn out from the signal line take-out opening 65 and the electrode introduction terminal 66 is sealed. The pressure reduction opening 64 is connected to a vacuum pump (not shown) and the pressure in the bell jar 32 is reduced. When aluminium of the substrate 2 reacts with the etching solution 8, for example, phosphoric acid, hydrogen is produced from the electrode 5. When the reaction is carried out under reduced pressure, the thus formed hydrogen is separated promptly and conveniently. Therefore, etching can be performed uniformly. When etching is carried out in such a reduced pressure chamber, visual inspection of the etching state of the substrate 2 becomes more difficult. However, since according to the present invention, etching can be carried out under optimum conditions without visual inspection as pointed out hereinbefore, the quality of electrical interconnections can be further improved in the embodiment of Fig. 12.

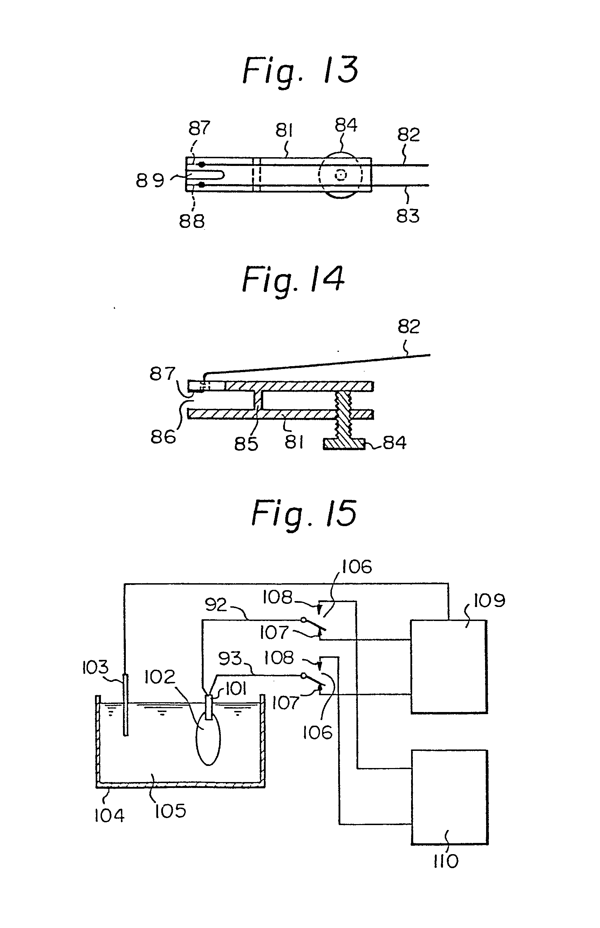

Fig. 13 is a top plan view showing a first embodiment of a connector according to the present invention and Fig. 14 is a cross-sectional view of the connector of Fig. 13.

Reference numeral 81 indicates a connector proper, and reference numerals 82 and 83 indicate a first connecting element and a second connecting element, respectively, for example, aluminium wires. Reference numeral 84 indicates a screw and reference numeral 85 indicates a fulcrum. Reference numeral 86 is a gap in which a semiconductor wafer is inserted, reference numerals 87 and 88 indicate contact portions and reference numeral 89 indicates a dividing groove.

The connector proper 81 and screw 84 are formed of a material for example, a fluorine resin, not corroded by an etching solution.

The semiconductor wafer 41 is inserted in the gap 86 of the connector so that a vacuum-deposited aluminium face of said wafer is facing upwards, and when the connector is fastened by the screw 84, the contact portions 87 and 88 of the elements 82 and 83 break the photoresist 44 (cf. Fig. 5) and are strongly pressed to the aluminium layer 43. The dividing groove 89 is disposed so that both the contact portions 87 and 88 are uniformly contacted with the aluminium layer 43.

Fig. 15 is a diagram illustrating the structure of an etching apparatus in which the connector of the present invention as illustrated in Figs. 13 and 14 is utilized. Reference numerals 101, 102, 103, 104, 105, 106, 107, 108, 109 and 110 indicate the connector of Figs. 13 and 14, a semiconductor wafer, a platinum wire acting as one electrode, an etching tank, an etching solution, a switch having two circuits, a break contact of the switch 106, a make contact of the switch 106, an etching monitoring circuit and a circuit for confirmation of connection of the connecting elements. References 92, 93 indicate aluminium wires which not only serve as the connecting elements 82, 83 but also as leads connecting these elements to the switch 106.

The intensity of the electric current produced when the platinum wire 103 is used as a positive pole and the semiconductor wafer 102 is used as a negative pole changes according to the area of aluminium. Therefore, this current is monitored by the etching monitoring circuit 109 and the progress of the etching is determined based on the detected current value.

However, when the contact between the semiconductor wafer 102 and the aluminium layer by the connector 101 is not firm or the wires 92 and 93 are, for example, cut, monitoring of etching becomes impossible. The connecting elements in contact with the aluminium layer of the semiconductor wafer 102 are constituted by wires formed of the same material as the electrically conductive layer (aluminium) of the semiconductor wafer 102, and these wires are not only very soft but will also be etched simultaneously with the conductive layer of the semiconductor wafer 102. Accordingly, if the aluminium wires are used repeatedly, it becomes difficult to provide a firm and sure contact between said aluminium wires and the aluminium layer of the semiconductor wafer 102. Therefore, connection of the aluminium wires 92 and 93 should be confirmed when they are used repeatedly.

When the switch 106 is depressed, the ends of the aluminium wires 92 and 93 of the connector 101 are connected to the make contact 108, and connection of the aluminium wires 92 and 93 is confirmed and checked by the connection confirming circuit 110. For confirmation of the proper connection of the wires 92 and 93 by the confirming circuit 110, there may be adopted a method in which a certain electric current is caused to flow from the aluminium wire 92 and the electric current is detected and measured at the aluminium wire 93. When the electrode contact portions 87 and 88 of the connector 101 are completely connected to the aluminium layer of the semiconductor wafer 102, confirmation of connection of the wires 92, 93 becomes possible for the first time.

In the present embodiment, two aluminium wires 92 and 93 are brought into contact with the semiconductor wafer 102. Needless to say, the intended effects can similarly be attained even if more than two connecting elements are used.

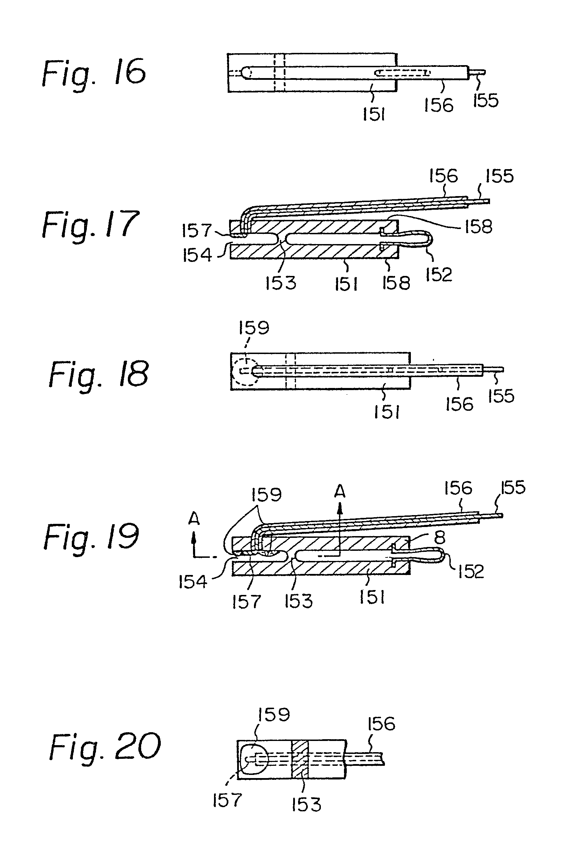

Fig. 16 is a top plan view showing another embodiment of the electrode connector according to the present invention, and Fig. 17 is a cross-sectional view of the connector of Fig. 16.

In Figs. 16 and 17, reference numerals 151, 152, 153, 154, 155, 156, 157 and 158 indicate a connector proper, a spring, a fulcrum, a gap into which a semiconductor wafer is inserted, an aluminium wire acting as a connecting element resist, a contact portion to be brought into contact with an electrically conductive layer, that is, an aluminium layer, of the inserted semiconductor wafer, and a pressure applying zone, respectively.

The pressure applying zone 158 of the connector is manually pressed to open the gap 154 and a semiconductor wafer is inserted into the gap 154 so that the vacuum-deposited aluminium layer of said semiconductor wafer faces upwards. When the manual pressure is released from the pressure applying zone 158, the contact portion of the aluminium wire 155 is brought into contact with the aluminium face of said semiconductor wafer by the elastic force of the spring 152.

In order to reduce the exposed area of the aluminium wire 155, the aluminium wire 155 is coated with the resist 156 except for the contact portion 157 to be brought into contact with the semiconductor wafer. When a fluorine resin FEP having a heat shrinkability is used as the resist 156, since the resist 156 adheres closely to the aluminium wire 155, the effects are further enhanced.

In the present embodiment, since the exposed area of the aluminium wire 155 as the electrode is reduced and the difference of the voltage before and after the terminal point of etching becomes large, the terminal point can be detected stably and assuredly with reduced errors, with the result that etching can be performed with a high precision.

Fig. 18 is a top plan view showing still another embodiment of the electrode connector of the present invention. Fig. 19 is a cross-sectional view of the electrode connector of Fig. 18 and Fig. 20 is a sectional view taken along line A—A of Fig. 19. Reference numerals 151 through 158 in Figs. 18 to 20 indicate the same elements and members illustrated in Figs. 16 and 17. Reference numeral 159 indicates an elastic resin. A silicone resin is preferably used as the elastic resin 159, because silicone resin has a high resistance to the corrosive action of an etching solution such as phosphoric acid and does not adversely effect a semiconductor wafer.

The periphery of the contact portion 157 of the aluminium wire 155 is surrounded by the resin 159 so that the height of the surrounding resin 159 is larger than the height of the contact portion 157. When a semiconductor wafer is inserted into the gap 154, since the resin 159 is deformed and crushed because of a high elasticity thereof, the contact portion 157 of the connecting element breaks the insulating layer of the semiconductor wafer and is connected to the aluminium layer as the electrically conductive layer. Since the peripheral portion of the contact portion 157 in the vicinity of the semiconductor wafer is covered with the resin 159, the contact point 157 is not immersed in the etching solution and the aluminium of this portion is left as is. More specifically, in the electrode connector of the present embodiment, although the contact portion 157 is brought into contact with the aluminium layer by a point contact, a high effect comparable to the effect attained by a broader face contact can be attained because of the presence of the resin 159. Furthermore, since the area of aluminium left after etching is broad and various diffusion zones are included therein, the output voltage can be made highly uniform and the terminal point of etching can be detected more precisely.

As will be apparent from the foregoing description, according to the present embodiment, since the peripheral portion of the aluminium wire 155 as the electrode is surrounded by an elastic resin 159 and the apparent contact area between the aluminium wire 155 and the electrically conductive layer is increased while separating the electrically conductive layer from an etching solution, the terminal point of etching can be detected stably and assuredly and detection errors can remarkably be reduced. Therefore, etching can be accomplished with an enhanced precision.

**Claims**

1. A method of forming electrical interconnections on a semiconductor substrate (41) formed with a number of semiconductor circuit elements, said method comprising depositing an electrically conductive layer (43) over substantially the entire surface of the semiconductor substrate (41), and etching the electrically conductive layer (43) to produce electrical interconnections in a pattern previously defined on the conductive layer (43) by a photolithographic process, characterised in that the etching process includes the operations of placing a connecting element (3) composed of the electrochemically same material as that of the electrically conductive layer (43) so that at least one point of said connecting element (3) is in contact with the electrically conductive layer (43), dipping the assembly in an etching solution (8) to perform wet chemical etching of the electrically conductive layer (43), and monitoring the progress of etching by monitoring the electric current flow produced in an external circuit by an electrochemical cell set up between the electrically conductive layer (43) acting as one electrode and another electrode (5) disposed in said solution (8) and constituted by an electric conductor composed of a material electrochemically different from the material of the electrically conductive layer (43), the cell electrode constituted by the conductive layer (43) being connected to the external circuit (6) by said connecting element (3).

2. A method according to Claim 1, wherein the etching rate W/T is calculated from the thickness W of the electrically conductive layer (43) and the time T required for the electric current flowing between the two electrodes (43, 5) to be reduced to a predetermined level, and etching is continued for a time

$$\frac{W'}{W} T$$

in which W' stands for a predetermined additional etching thickness, after the current has fallen to said predetermined level.

3. A method according to claim 1, wherein the etching rate is measured at predetermined intervals and etching is stopped when a value P represented by the following formula becomes substantially zero:

$$P = SQ - \sum_{M1}^{M} (R\Delta M)$$

wherein S stands for the ratio of an additional etching thickness W' to the initial thickness W of the electrically conductive layer (43), Q stands for the total etching thickness to a primary terminal point M1 determined by the monitored current falling to a predetermined level, R stands for the etching rate after a time M1 at the primary terminal point, and M stands for the time interval between measurements.

4. Apparatus for forming electrical interconnections on a semiconductor substrate (41) provided with a number of semiconductor circuit elements, said apparatus comprising a vessel (1) containing an etching solution (8) for etching an electrically conductive layer (43) provided over substantially the entire surface of said semiconductor substrate, whereby to form said electrical interconnections; a connecting element (3) composed of the electrochemically same material as that of the electrically conductive layer (43), said element being placed, in use, in contact with a part of said electrically conductive layer (43); an electrode (5) disposed in said etching solution (8) and composed of a material electrochemically different from the material of said electrically conductive layer (43), an external circuit (6) connected between the connecting element (3) and the electrode (5), and means (10) for monitoring the electric current flow produced in the external circuit by the electrochemical cell set up between the electrically conductive layer (43) and the said electrode (5) during etching.

5. Apparatus for forming electrical interconnections according to Claim 4, further comprising etching rate measuring means (6, 10) for measuring the etching rate up to a nominal etching terminal point determined by a drop in monitored current to a predetermined level, memory means (38, 40) for storing information indicative of an additional etching thickness, and timing means (26) for determining an additional etching time beyond said terminal point which at the said measured etching rate would result in etching of said additional etching thickness.

6. Apparatus for forming electrical interconnections according to Claim 5, wherein said memory means is arranged to memorize the ratio of said additional etching thickness to the initial thickness of the electrically conductive layer (43).

7. Apparatus for forming electrical interconnections according to Claim 5, wherein a connector is provided which includes at least two connecting elements, said connector (81) being arranged to connect said elements to the semiconductor subtrate having a resist adhering to the electrically conductive layer by press-adhering these elements to the semiconductor substrate.

8. Apparatus for forming electrical interconnections according to Claim 7, wherein in said connector for connecting the connecting elements to the semiconductor substrate said connecting elements are coated with the resist so that the exposed areas of the electrodes are reduced.

9. Apparatus for forming electrical interconnections according to Claim 7, wherein in said connector for connecting the connecting elements to the semiconductor substrate having a resist adhering to the electrically conductive layer, the peripheries of the elements to be brought in contact with the substrate are surrounded by an elastic resin.

10. Apparatus for forming electrical interconnections according to Claim 9, wherein the elastic resin is a silicone resin.

11. An apparatus for forming electrical interconnections according to Claim 9, wherein the thickness of the elastic resin is larger than the height of the elements.

## Revendications

1. Procédé de formation d'interconnexions électriques sur un substrat semiconducteur (41) doté d'un certain nombre d'éléments de circuit semiconducteurs, ledit procédé consistant à faire déposer une couche électriquement conductrice (43) sur sensiblement toute la surface du substrat semiconducteur (41), et inciser la couche électriquement conductrice (43) afin de produire des interconnexions électriques suivant une configuration préalablement définie sur la couche conductrice (43) par un processus photolithographique, caractérisé en ce que le processus d'incision comporte les opérations suivantes consistant à placer un élément de connexion (3) qui est constitué du même matériau, du point de vue électrochimique, que la couche électriquement conductrice (43) si bien qu'au moins un point dudit élément de connexion (3) est en contact avec la couche électriquement conductrice (43), à plonger l'ensemble dans une solution d'incision (8) afin d'effectuer une incision chimique par voie humide de la couche électriquement conductrice (43), et à contrôler la progression de l'incision en contrôlant le passage du courant électrique produit dans un circuit externe par une cellule électrochimique installée entre la couche électriquement conductrice (43), faisant fonction de première électrode et une autre électrode (5) disposée dans ladite solution (8) et constituée par une conducteur électrique composé d'un matériau électrochimiquement différent du matériau de la couche électriquement conductrice (43), l'électrode de la cellule constituée par la couche conductrice (43) étant connectée au circuit externe (6) par ledit élément de connexion (3).

2. Procédé selon la revendication 1, où on calcule la vitesse d'incision W/T à partir de l'épaisseur W de la couche électriquement conductrice (43) et du temps T nécessaire pour que le courant électrique passant entre les deux électrodes (43, 5) soit réduit à un niveau prédéterminé, et on poursuit l'incision pendant une durée W'.T/W, où W' correspond à une épaisseur d'incision supplémentaire prédéterminée, après que le courant est tombé audit niveau prédéterminé.

3. Procédé selon la revendication 1, où on mesure la vitesse d'incision à intervalles prédéterminés et on arrête l'incision lorsqu'une valeur P représentée par la formule suivante devient sensiblement nulle:

$$P = SQ - \sum_{M1}^{M} (R\Delta M)$$

où S désigne le rapport d'une épaisseur d'incision supplémentaire W' à l'épaisseur initiale W de la couche électriquement conductrice (43), Q désigne l'épaisseur d'incision totale jusqu'à un point final principal M1 déterminé par le fait que le courant contrôlé est tombé à un niveau prédéterminé, R désigne la vitesse d'incision après un temps M1 correspondant au point final principal, et M désigne l'intervalle de temps entre les mesures.

4. Appareil destiné à former des interconnexions électriques sur un substrat semiconducteur (41) doté d'un certain nombre d'éléments de circuit semiconducteurs, ledit appareil comprenant un récipient (1) contenant une solution d'incision (8) servant à inciser une couche électriquement conductrice (43) disposée sur sensiblement toute la surface dudit substrat semiconducteur de manière à former lesdites interconnexions électriques; un élément de connexion (3) constitué du même matériau, du point de vue électrochimique, que la couche électriquement conductrice (43), ledit élément étant placé, en utilisation, en contact avec une partie de ladite couche électriquement conductrice (43); une électrode (5) disposée dans ladite solution d'incision (8) et constituée d'un matériau électrochimiquement différent du matériau de ladite couche électriquement conductrice (43), un circuit externe (6) connecté entre l'élément de connexion (3) et l'électrode (5) et un moyen (10) servant à contrôler le passage du courant électrique produit dans le circuit externe par la cellule électrochimique constituée entre la couche électriquement conductrice (43) et ladite électrode (5) pendant l'incision.

5. Appareil destiné à former des interconnexions électriques selon la revendication 4, comprenant en outre un moyen (6, 10) de mesure de la vitesse d'incision servant à mesurer la vitesse d'incision jusqu'à un point final nominal d'incision qui est déterminé par une chute du courant contrôlé à un niveau prédéterminé, un moyen de mémorisation (38, 40) servant à emmagasiner une information indicative d'une épaisseur d'incision supplémentaire, et un moyen minuteur (26) servant à déterminer un temps d'incision supplémentaire au-delà dudit point final, ce qui, à ladite vitesse d'incision mesurée, conduit à inciser ladite épaisseur d'incision supplémentaire.

6. Appareil destiné à former des interconnexions électriques selon la revendication 5, où ledit moyen de mémorisation est conçu pour mémoriser le rapport de ladite épaisseur d'incision supplémentaire à l'épaisseur initiale de la couche électriquement conductrice (43).

7. Appareil destiné à former des interconnexions électriques selon la revendication 5, où il est prévu un élément connecteur qui comporte au moins deux éléments de connexion, ledit élément connecteur (81) étant conçu pour connecter lesdits éléments de connexion au substrat portant un vernis sensible collé à la couche électriquement conductrice par un collage par pression de ces éléments sur le substrat semiconducteur.

8. Appareil destiné à former des interconnexions électriques selon la revendication 7, où dans ledit élément connecteur servant à connecter les éléments de connexion au substrat semiconducteur, lesdits éléments de connexion sont revêtus par le vernis sensible de manière que les aires exposées des électrodes soient réduites.

9. Appareil destiné à former des interconnexions électriques selon la revendication 7, où, dans ledit élément connecteur servant à connecter les éléments de connexion au substrat semiconducteur portant un vernis sensible collé à la couche électriquement conductrice, les pourtours des éléments de connexion à mettre en contact avec le substrat sont entourés par une résine élastique.

10. Appareil destiné à former des interconnexions électriques selon la revendication 9, où la résine élastique est une résine de silicone.

11. Appareil destiné à former des interconnexions électriques selon la revendication 9, où l'épaisseur de la résine élastique est plus grande que la hauteur des éléments de connexion.

**Patentansprüche**

1. Verfahren zur Formung elektrischer Leiterbahnen auf einem Halbleiterträger (41), der mit einer Reihe von Halbleiterschaltungselementen ausgebildet ist, wobei bei dem Verfahren eine elektrisch leitfähige Schicht (43) auf weitgehend der gesamten Oberfläche des Halbleiterträgers (41) abgeschieden und die elektrisch leitfähige Schicht (43) zur Erzeugung von elektrischen Leiterbahnen in einem zuvor auf der leitfähigen Schicht (43) durch einen photolithographischen Prozeß vorbestimmten Muster geätzt wird, dadurch gekennzeichnet, daß der Ätprozeß darin besteht, daß ein Verbindungselement (3), das elektrochemisch aus demselben Material besteht wie die elektrisch leitfähige Schicht (43), so in Stellung gebracht wird, daß mindestens ein Punkt des Verbindungselements (3) in Kontakt mit der elektrisch leitfähigen Schicht (43) ist, daß die Anordnung zur chemischen Naßätzung der elektrisch leitfähigen Schicht (43) in eine Ätzlösung (8) getaucht wird und daß das Fortschreiten der Ätzung durch Überwachen des elektrischen Stromflusses überwacht wird, der in einem äußeren Stromkreis durch eine elektrochemische Zelle erzeugt wird, die zwischen der elektrisch leitfähigen Schicht (43), die als eine Elektrode wirkt, und einer anderen Elektrode (5) eingesetzt ist, die in die Lösung (8) eintaucht und durch einen elektrischen Leiter aus einem Material gebildet wird, das sich von dem Material der elektrisch leitfähigen Schicht (43) elektrochemisch unterscheidet, wobei die durch die leitfähige Schicht (43) gebildete Zellenelektrode mit dem äußeren Stromkreis (6) durch das Verbindungselement (3) verbunden ist.

2. Verfahren nach Anspruch 1, bei dem das Ätzverhältnis W/T aus der Dicke W der elektrisch leitfähigen Schicht (43) und der Zeit T berechnet wird, die erforderlich ist, um den elektrischen Stromfluß zwischen den beiden Elektroden (43, 5) auf ein vorbestimmtes Maß herabzusetzen, und daß die Ätzung für eine Zeit

$$\frac{W'}{W} \cdot T$$

durchgeführt wird, wobei W' für eine vorbestimmte zusätzliche Ätzdicke steht, nachdem der Strom auf den vorbestimmten Wert abgefallen ist.

3. Verfahren nach Anspruch 1, bei dem das Ätzverhältnis in vorbestimmten Zeitabständen gemessen und das Ätzen beendet wird, wenn ein Wert P, repräsentiert durch die folgende Formel

$$P = SQ - \sum_{M1}^{M} (R\Delta M),$$

weitgehend Null erreicht, wobei S das Verhältnis einer zusätzlichen Ätzdicke W' zu der Anfangsdicke W der elektrisch leitfähigen Schicht (43), Q die Gesantätzdicke auf einen ersten Endpunkt M1, vorbestimmt durch den überwachten Stromabfall auf ein vorbestimmtes Maß, R das Ätzverhältnis nach einer Zeit M1 bei dem ersten Endpunkt und M den Zeitabstand zwischen den Messungen bedeutet.

4. Vorrichtung zur Formung elektrischer Leiterbahnen auf einem Halbleiterträger (41), der mit einer Reihe von Halbleiterschaltungselementen versehen ist, wobei die Vorrichtung aus einem Behälter (1), der die Ätzlösung (8) zum Ätzen einer elektrisch leitfähigen Schicht (43) enthält, welche auf weitgehend der gesamten Oberfläche des Halbleiterträgers vorgesehen ist, wodurch die elektrischen Leiterbahnen ausgebildet werden; aus einem Verbindungselement (3), das elektrochemisch aus demselben Material besteht wie die elektrisch leitfähige Schicht (43), wobei das Element be der Anwendung so in Stellung gebracht wird, daß es in Kontakt mit einem Teil der elektrisch leitfähigen Schicht ist; einer Elektrode (5), die in die Ätzlösung (8) eintaucht und aus einem Material besteht, das sich elektrochemisch von dem Material unterscheidet, aus dem die elektrisch leitfähige Schicht (43) besteht, einen äußeren Stromkreis (6) zwischen dem Verbindungselement (3) und der Elektrode (5) und Einrichtungen (10) zum Überwachen des elektrischen Stromflusses besteht, der in dem äußeren Stromkreis durch die zwischen der elektrisch leitfähigen Schicht (43) und der Elektrode (5) eingesetzte elektrochemische (Zelle während des Ätzens erzeugt wird.

5. Vorrichtung zur Formung elektrischer Leiterbahnen nach Anspruch 4, weiterhin bestehend aus Ätzverhältnismeßeinrichtungen (6, 10) zum Messen des Ätzerverhältnisses bis zu einem durch einen Abfall des überwachten Stromes auf ein vorbestimmtes Maß vorbestimmten nominalen Ätzendpunkt, aus einer Speichereinrichtung (38, 40) zum Speichern von eine zusätzliche Ätzdicke anzeigenden Informationen und aus Zeitsteuerungseinrichtungen (26) zum Bestimmen einer zusätzlichen Ätzzeit über den Endpunkt hinaus, welcher bei dem gemessenen Ätzverhältnis zu einer Ätzung der zusätzlichen Ätzdicke führen würde.

6. Vorrichtung zur Formung elektrischer Leiterbahnen nach Anspruch 5, bei der die Speichereinrichtung zum Speichern des Verhältnisses der zusätzlichen Ätzdicke zu der Anfangsdicke der elektrisch leitfähigen Schicht (43) eingerichtet ist.

7. Vorrichtung zur Formung elektrischer Leiterbahnen nach Anspruch 5, bei der ein Anschluß vorgesehen ist, der aus mindestens zwei Verbindungselementen besteht, wobei der Anschluß (81) diese Elemente mit dem Halbleiterträger, auf dem ein Photolack haftet, durch Preßhaftung dieser Elemente mit dem Halbleiterträger verbindet.

8. Vorrichtung zur Formung elektrischer Leiterbahnen nach Anspruch 7, wobei bei diesem Anschluß zum Verbinden der Verbindungselemente mit dem Halbleiterträger diese Verbindungselemente mit dem Photolack beshichtet sind, so daß die freiliegenden Flächen der Elektroden verkleinert sind.

9. Vorrichtung zur Formung elektrischer Leiterbahnen nach Anspruch 7, wobei bei diesem Anschluß zum Verbinden der Verbindungselemente mit dem Halbleiterträger, der einen an der elektrisch leitfähigen Schicht haftenden Photolack aufweist, die Außenflächen der mit dem Träger in Kontakt zubringenden Elemente mit einem elastischen Harz überzogen sind.

10. Vorrichtung zur Formung elektrischer Leiterbahnen nach Anspruch 9, wobei das elastische Harz ein Silikonharz ist.

11. Vorrichtung zur Formung elektrischer Leiterbahnen nach Anspruch 9, wobei die Dicke des elastischen Harzes größer ist als Höhe der Elemente.

Fig. 1

Fig. 2

## Fig. 3

## Fig. 4

*Fig. 5*

*Fig. 6*

*Fig. 8*

Fig. 7

*Fig. 9*

*Fig. 10*

## Fig. 11

## Fig. 12

*Fig. 13*

*Fig. 14*

*Fig. 15*

*Fig. 16*

*Fig. 17*

*Fig. 18*

*Fig. 19*

*Fig. 20*